(19) Europäisches Patentamt
European Patent Office
Office européen des brevets

(11) **EP 4 737 919 A1**

(12) **EUROPEAN PATENT APPLICATION**
published in accordance with Art. 153(4) EPC

(43) Date of publication:
**06.05.2026 Bulletin 2026/19**

(21) Application number: **24832105.1**

(22) Date of filing: **28.06.2024**

(51) International Patent Classification (IPC):
*G01R 31/367* (2019.01)    *G01N 25/18* (2006.01)
*G01R 31/382* (2019.01)    *G01R 31/385* (2019.01)
*G01R 31/389* (2019.01)    *G01R 31/392* (2019.01)
*H01M 10/48* (2006.01)

(52) Cooperative Patent Classification (CPC):
Y02E 60/10

(86) International application number:
**PCT/JP2024/023511**

(87) International publication number:
**WO 2025/005247 (02.01.2025 Gazette 2025/01)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.06.2023 JP 2023107882**

(71) Applicant: HORIBA, Ltd.
**Kyoto-shi Kyoto 601-8510 (JP)**

(72) Inventors:
• **MATSUNAGA, Shimpachi**
 **Kyoto-shi, Kyoto 601-8510 (JP)**
• **HATAKEYAMA, Hiroshi**
 **Kyoto-shi, Kyoto 601-8510 (JP)**
• **TATSUKAWA, Shogo**
 **Kyoto-shi, Kyoto 601-8510 (JP)**

(74) Representative: **Müller Hoffmann & Partner
Patentanwälte mbB
St.-Martin-Strasse 64
81541 München (DE)**

(54) **BATTERY CASE EVALUATION SYSTEM, BATTERY CASE EVALUATION PROGRAM, AND BATTERY CASE EVALUATION METHOD**

(57) This invention is a battery case evaluation system 100 for evaluating thermal characteristics of a battery case (BC) constituting a battery pack or a component of the battery case (BC). The battery case (BC) comprises a simulated battery 10 that is installed within the battery case (BC) and that is to simulate thermal behavior of the actual battery which is a component of the battery pack, a power supply device 20 that supplies power to the simulated battery 10, and a control device 30 that controls the power supply device 20. The control device 30 comprises a parameter receiving unit 31 that receives an input profile indicating time-dependent change of a current, a voltage, or power supplied to the actual battery as one of evaluation parameters, a resistance value calculation unit 331 that calculates a resistance value of the actual battery which changes over time based on simulated battery temperature and the input profile, and a power supply control unit 33 that controls the power supply device 20 using the resistance value calculated by the resistance value calculation unit 331.

FIG. 4

## Description

### Technical field

The present invention relates to a battery case evaluation system, a battery case evaluation program, and a battery case evaluation method.

### Background art

For example, lithium-ion batteries installed in vehicles, etc., require control of their operating temperature during use due to reasons such as their narrow operating temperature range.

To appropriately control the operating temperature of a lithium-ion battery, the heat exchange between the battery case that houses the battery and that controls the temperature of the battery and the battery that is housed in the battery case and/or the heat exchange between the interior and the exterior of the battery case when the battery is housed within it, is crucial. Therefore, understanding the thermal behavior of the battery is necessary for developing the battery case.

However, during early stages of the battery case development, the battery itself is often being designed concurrently. This frequently results in insufficient quantities of actual batteries being available. Furthermore, battery case designers may not be thoroughly familiar with handling methods of actual batteries. Consequently, simulated batteries that mimic the thermal behavior of actual batteries are required.

Therefore, conventionally, resistive elements such as metal plates or rods with internal resistance close to that of the battery have been used as simulated batteries. By applying a current with a predetermined profile to this simulated battery, the thermal behavior of the actual battery has been roughly simulated.

However, actual batteries exhibit fluctuating resistance values in real time due to temperature changes during operation. Conventional methods completely ignored these resistance fluctuations, failing to accurately simulate the actual battery's thermal behavior. Consequently, it was impossible to accurately evaluate the thermal characteristics of the battery case or its components.

### Prior art documents

### Patent documents

Patent document 1: Japanese Unexamined Patent Application Publication No. 2022-151635

### Summary of the invention

### Problems to be solved by the invention

Therefore, the present invention is intended to solve the above-mentioned problems. Its objective is to enable more accurate simulation of battery thermal behavior than conventional methods, thereby allowing more efficient evaluation of battery cases.

### Means to solve the problem

Namely, the battery case evaluation system according to the present invention is a battery case evaluation system for evaluating thermal characteristics of a battery case constituting a battery pack or a component of the battery case. A simulated battery installed within the battery case for simulating thermal behavior of an actual battery, which is a component part of that battery pack; a temperature detection device for detecting a simulated battery temperature, which is a temperature of the simulated battery; a power supply device for supplying power to the simulated battery; and a control device for controlling the power supply device. The control device comprises a parameter receiving unit that receives an input profile indicating time-dependent change in a current, or a voltage, or power supplied to the actual battery as one of evaluation parameters, a resistance value calculation unit that calculates a resistance value of the actual battery, which changes over time, based on the simulated battery temperature and the input profile, and a power supply control unit that controls the power supply device using the resistance value calculated by the resistance value calculation unit.

According to this battery case evaluation system, the resistance value of the actual battery, which changes over time, is calculated based on the simulated battery temperature and the input profile. The power supply device is then controlled using this calculated resistance value. This allows the thermal behavior of the actual battery to be accurately simulated while considering the constantly fluctuating resistance value of the actual battery, enabling efficient evaluation of the battery case.

Furthermore, using a simulated battery avoids the risk of ignition that could occur with an actual battery (e.g., ignition due to electrode damage from impact during handling of the actual battery or ignition that could occur if the battery is accidentally overcharged).

The thermal behavior of the actual battery includes the exothermic behavior and/or the endothermic behavior of the actual battery.

However, actual batteries exhibit fluctuating resistance values and a state of charge (hereinafter also referred to as an SOC) during operation. Conventional methods completely disregard these SOC fluctuations, failing to accurately simulate the thermal behavior of the actual batteries.

Therefore, it is preferable that the control device further comprises an SOC calculation unit that calculates an SOC of the actual battery, which changes over time, based on the input profile, and that the resistance value calculation unit calculates the resistance value of the actual battery using the SOC calculated by the SOC calculation unit, in addition to the simulated battery temperature and the input profile.

With this configuration, the resistance value of the actual battery is calculated while considering its constantly fluctuating SOC, enabling more accurate simulation of the actual battery's thermal behavior.

Furthermore, since the SOC is calculated based on the input profile, it eliminates the need for processes that repeatedly charge and discharge the actual battery to generate SOC values under various conditions.

It is preferable that the parameter receiving unit receives a battery capacity of the actual battery, and that the SOC calculation unit calculates the SOC that changes over time using the input profile and the battery capacity.

This allows the thermal behavior to be simulated for the actual batteries with various battery capacities.

It is preferable that the parameter receiving unit receives, in addition to the input profile, at least one of an initial SOC of the actual battery or an SOH of the actual battery as the evaluation parameter.

This allows simulating the thermal behavior of the actual battery under various operating conditions.

As a specific implementation for calculating the resistance value of the actual battery, the resistance value calculation unit may include a conversion table for converting the evaluation parameter received by the parameter receiving unit into a resistance value, or a simulation model that outputs the resistance value using the evaluation parameter received by the parameter receiving unit.

The control device further comprises an entropy change calculation unit that calculates an entropy change generated accompanied by charging and discharging of the actual battery. It is preferable that the power supply control unit controls the power supply device using both the resistance value calculated by the resistance value calculation unit and the entropy change calculated by the entropy change calculation unit.

In the actual battery, in addition to the Joule heating due to the internal resistance, reaction heat associated with the entropy changes caused by electrochemical reactions during charge and discharge also occurs. Therefore, with this configuration, considering the reaction heat associated with charge and discharge in addition to the Joule heating allows for more accurate simulation of the battery's thermal behavior.

As a specific implementation for calculating the entropy change of the actual battery, the entropy change calculation unit may calculate the entropy change using table data or calculation formula data for converting the SOC calculated by the SOC calculation unit into the entropy change occurring in the actual battery.

It is preferable that the simulated battery comprises a heat generating element to which power is supplied from the power supply device, and a heat diffusing element that holds the heat generating element and that diffuses the heat emitted by the heat generating element, wherein at least one of the heat generating element or the heat diffusing element is formed with a predetermined pattern that is capable of reproducing the surface temperature distribution of the actual battery.

Here, "capable of reproducing the surface temperature distribution" is used in a sense that includes not only cases where the entire surface temperature distribution is reproduced, but also cases where only part of the surface temperature distribution is reproduced.

This enables the reproduction of various surface temperature distributions of the actual battery, contributing to the simulation of thermal behavior such as heat conduction between the battery and surrounding components.

It is preferable that the heat generating element or the heat diffusing element is formed with a predetermined dense and sparse pattern or a predetermined convex/concave pattern.

This allows the thermal behavior and/or the thermal diffusion behavior of the actual battery to be simulated using the simulated battery.

It is preferable that the pattern of the heat generating element or the heat diffusing element is obtained by applying a machine learning model to the surface temperature distribution of the actual battery.

This allows the pattern for achieving the target surface temperature distribution of the simulated battery to be obtained without resorting to often cumbersome theoretical analysis.

Furthermore, it is preferable that the battery case evaluation system is configured such that at least one of the heat generating element or the heat diffusing element is formed with a predetermined pattern capable of reproducing the time-dependent change in the surface temperature of the actual battery.

This enables reproduction of various time-dependent changes in the surface temperature of the actual battery, allowing for more accurate simulation of thermal behavior, such as heat conduction between the actual battery and surrounding components.

Moreover, a battery case evaluation program according to the present invention is a program for evaluating thermal characteristics of a battery case constituting a battery pack or a component part of the battery case, and comprises a simulated battery that is installed in the battery case for simulating thermal behavior of an actual battery which is a component part of the battery pack, a temperature detection device that detects a simulated battery temperature, which is the temperature of the simulated battery, a power supply device that supplies power to the simulated battery, and a control device that controls the power supply device, and makes the control device produce functions as a parameter receiving unit that receives an input profile indicating the time-dependent change in a current, a voltage, or power supplied to the actual battery as one of the evaluation parameters, a resistance value calculation unit that calculates a resistance value of the actual battery, which changes over time, based on the simulated battery temperature and the input profile, and a power supply control unit that controls the power supply device using the resistance value calculated by the resistance value calculation unit.

Furthermore, the battery case evaluation method according to the present invention is a battery case evaluation method for evaluating thermal characteristics of a battery case constituting a battery pack or a component of the battery case, and is used together with a battery case evaluation system comprising a simulated battery that is installed in the battery case for simulating thermal behavior of an actual battery which is a component part of the battery pack, a temperature detection device that detects simulated battery temperature, which is a temperature of the simulated battery, a power supply device that supplies power to the simulated battery, and a control device that controls the power supply device, wherein comprising a step of causing the control device to receive an input profile indicating time-dependent change of a current, a voltage, or power supplied to the actual battery as one of evaluation parameters, a step of causing the control device to calculate a resistance value of the actual battery, which changes over time, based on the simulated battery temperature and the input profile, and a step of causing the control device to control the power supply device using the calculated resistance value.

The battery case evaluation program and the battery case evaluation method can achieve effects similar to those of the aforementioned battery case evaluation system.

## Effect of the Invention

According to the present invention configured in this manner, the thermal behavior of the battery can be simulated with greater accuracy than conventional methods, enabling efficient evaluation of the battery case.

## Brief Description of the Drawings

[Fig. 1] A schematic diagram showing an overall configuration of a battery case evaluation system according to one embodiment of the present invention.

[Fig. 2] A schematic diagram showing a configuration of a simulated battery case of the same embodiment.

[Fig. 3] A functional block diagram showing a function of a control device of the same embodiment.

[Fig. 4] A flowchart diagram showing an operation of a control device of the same embodiment.

[Fig. 5] A schematic diagram showing calculation data of the control device of the same embodiment.

[Fig. 6] A schematic diagram showing a configuration of a simulated battery for another embodiment.

[Fig. 7] A schematic diagram showing a configuration of a simulated battery for another embodiment.

[Fig. 8] A schematic diagram showing an overall configuration of a battery case evaluation system for another embodiment.

[Fig. 9] A flowchart diagram showing an operation of another control device.

[Fig. 10] A functional block diagram showing a function of a control device for another embodiment.

## Best mode for embodying the invention

The following describes one embodiment of a battery case evaluation system according to the present invention with reference to drawings.

The battery case evaluation system of this embodiment is for evaluating thermal characteristics of a battery case constituting a battery pack or components of the battery case mounted on a vehicle such as an electric vehicle or a hybrid vehicle.

The battery case or its component to be evaluated need not be limited to those installed in vehicles, they may also be installed in various other mobile entities such as ships, trains, or aircrafts. Furthermore, the battery case itself may constitute one of these various mobile entities.

The battery pack comprises, for example, an actual battery (specifically, for example, a lithium-ion battery) and a battery case that houses the actual battery. The battery case comprises reinforcing members such as a frame, cooling members such as a cooling plate, insulation material that blocks heat from the outside, and or electronic devices such as a junction box. The battery case may include temperature control equipment such as a cooling fan to regulate temperature of the battery case or the battery, and a control device to control the temperature control equipment. And the control device may control the temperature control equipment based on the temperature of the battery. The actual battery may be a single actual cell, which is an actual battery cell, or an actual battery module composed of multiple actual cells.

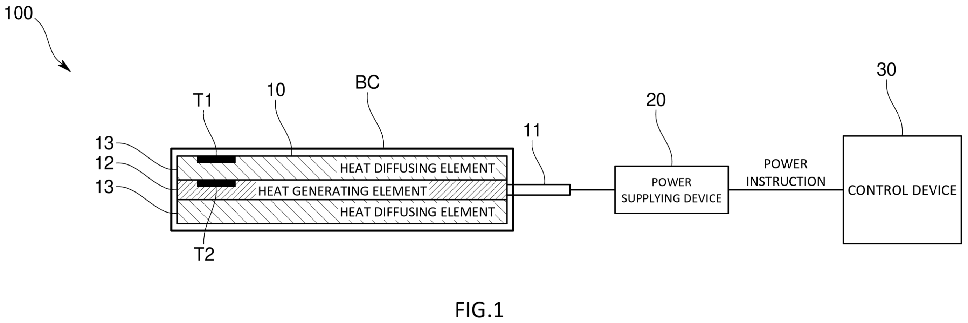

Specifically, the battery case evaluation system 100, as shown in Fig. 1, comprises a simulated battery 10, a power supply device 20 that supplies power to the simulated battery 10, and a control device 30 that controls the power supply device 20.

The simulated battery 10 is to simulate heat generation of the actual battery installed within the aforementioned battery case (BC) and may be a simulated single cell that simulates an actual single cell, or a simulated battery module that simulates an actual battery module composed of multiple simulated cells.

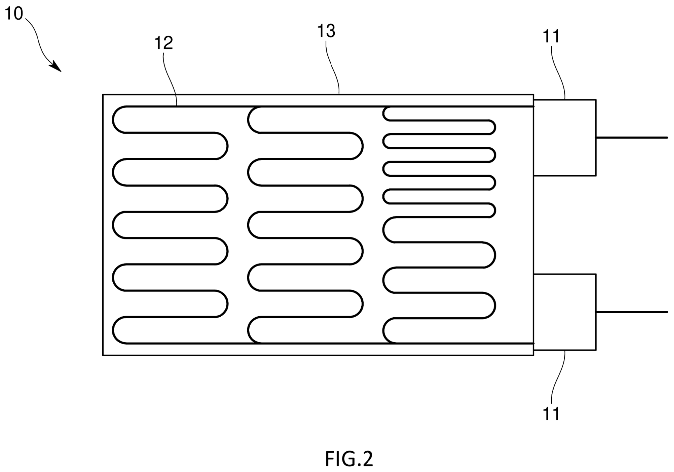

The simulated battery 10 in this embodiment is a simulated cell unit that simulats an actual cell unit. As shown in Fig. 2, the simulated battery 10 comprises a tab 11 connected to the power supply device 20 via wiring, a heat generating element 12 supplied with power from the power supply device 20 via the tab 11, and a heat diffusing element 13 that diffuses heat generated by the heat generating element 12.

Tab 11 is connected to the power supply device 20 via wiring and is also connected to the heat generating element 12, for example, by welding, and generates heat when the power is supplied. This tab 11 may utilize the actual tab 11 welded to the electrode (negative or positive) constituting the actual battery, or it may be a replica mimicking the shape, material, etc., of the tab 11.

The heat generating element 12 generates heat when power is supplied. Specifically, the heat generating element 12 can be configured using various heaters such as wire heaters, sheet heaters, or spot heaters.

The heat diffusing element 13 holds the heat generating element 12 and is made of a material having the same or similar thermal conductivity as the actual cell constituting the actual battery. Here, a pair of the heat diffusing elements 13 hold the heat generating element 12 by sandwiching it, but the heat generating element 12 may be provided on only one side.

In the configuration described above, the battery case evaluation system 100 of this embodiment further comprises, as shown in Fig, 1, a first temperature detection device T1 for detecting the simulated battery temperature, which is the temperature of the simulated battery 10, and a second temperature detection device T2 for detecting the heat generating element temperature, which is the temperature of the heat generating element 12. The first temperature detection device T1 is provided on the heat diffusing element 13, and the second temperature detection device T2 is provided on the heat generating element 12.

One or two or more first temperature detection devices T1 and one or two or more second temperature detection devices T2 may each be used.

For example, when two or more first temperature detection devices T1 are used, the average value of the temperature values obtained by those first temperature detection devices T1 may be used. The advantage of this is that obtaining the average surface temperature distribution allows stable reproduction of the surface temperature distribution without bias toward the high-temperature or low-temperature side of the distribution.

Conversely, for example, when evaluating by focusing on areas distributed at high temperatures within the surface temperature distribution, it is sufficient to install only one first temperature detection device T1 near the high-temperature side.

Furthermore, the simulated battery 10 of this embodiment has at least one of the heat generating element 12 or the heat diffusing element 13 formed in a predetermined pattern capable of reproducing the surface temperature distribution of the actual battery. This enables reproduction of the actual battery's thermal behavior, specifically reproducing not only the exothermic behavior but also the endothermic behavior of the actual battery.

In this embodiment, "capable of reproducing the surface temperature distribution" is used to mean not only cases where the entire surface temperature distribution is reproduced, but also cases where a portion of the surface temperature distribution is reproduced.

In this embodiment, as shown in Fig. 2, the heat generating element 12 is formed with a predetermined dense and sparse pattern.

More specifically, the heat generating element 12 in this embodiment is formed as a line extending, for example, from one tab 11 to the other tab 11, arranged in a serpentine manner on the heat diffusing element 13. The surface of the heat diffusing element 13 includes regions where the spacing between adjacent heat generating elements 12 is narrow and regions where the spacing between adjacent heat generating elements 12 is wide. That is, the surface of the heat diffusing element 13 holding the heat generating elements 12 has regions where the heat generating elements 12 are sparsely arranged and regions where the heat generating elements 12 are densely arranged. This configuration allows the surface temperature in the densely arranged region to be higher than in the sparsely arranged region.

In this embodiment, the heat diffusing element 13 is not formed with a specific pattern but is, for example, a simple flat plate. However, the heat diffusing element 13 may be formed with a specific pattern instead of or in addition to the heat generating elements 12.

The power supply device 20, as shown in Fig. 1, receives a power instruction from the control device 30 and supplies power corresponding to the instruction to the simulated battery 10.

The power supplied from this power supply device 20 is feedback-controlled by the control device 30. More specifically, the power is feedback-controlled so that the surface temperature distribution or total heat generation of the simulated battery 10 approaches the surface temperature distribution or total heat generation of the actual battery.

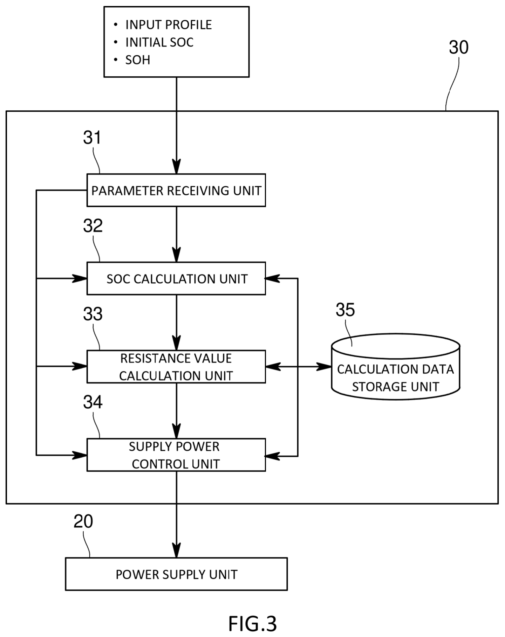

The control device 30 is physically equipped with a CPU, a memory, etc. Functionally, it performs the functions of a parameter receiving unit 31, an SOC calculation unit 32, a resistance value calculation unit 33, and a supply power control unit 34, as shown in Fig. 3, through the cooperative operation of the CPU and its peripheral devices according to the battery case evaluation program stored in the aforementioned memory.

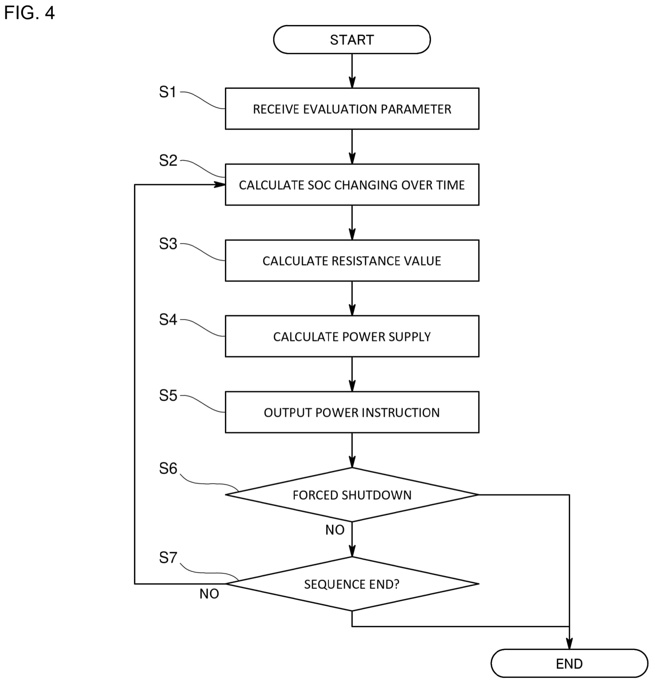

The operation of the control device 30 is described below with reference to the flowchart in Fig. 4, also serving to explain each part.

First, the parameter receiving unit 31 receives an input profile indicating the time-dependent change in the current, the voltage, or the power applied to the actual battery as at least one evaluation parameter (S1).

In this embodiment, in the battery case evaluation system for evaluating the thermal characteristics of the battery case (BC) constituting the battery pack or the components of the battery case (BC), the evaluation parameters are a parameter installed within the battery case (BC) and required for the simulated battery to simulate the heat generation of the actual battery, which is a component of the battery pack and a parameter for simulating the thermal behavior (specifically, the exothermic behavior) of the battery case (BC), which is a subject of evaluation in this battery case evaluation system 100 or the components of the battery case (BC).

These evaluation parameters are necessary for calculating the supply power supplied from the power supply device 20 to the simulated battery 10. More specifically, these evaluation parameters are necessary for obtaining a resistance value of the actual battery, which is an unknown quantity when calculating the supply power.

Furthermore, since the resistance value of the actual battery fluctuates moment by moment in response to temperature changes during operation when the currents indicated by the aforementioned input profile are applied to the actual battery, calculating this resistance value is crucial for calculating the supply power to the simulated battery 10. This is because the supply power to the simulated battery 10 is calculated based on the ratio of the resistance value of the actual battery to the resistance value of the simulated battery 10.

The parameter receiving unit 31 of this embodiment receives the input profile indicating the time-dependent change of the current applied to the actual battery 10 as at least one of the evaluation parameters.

This input profile is created in advance by the user and input into the control device 30. Specifically, the input profile is a current waveform represented as a graph with one axis set to time and the other axis set to a current value.

The parameter receiving unit 31 of this embodiment, as shown in Fig. 3, receives at least one of the initial SOC of the actual battery or the SOH of the actual battery as the evaluation parameter in addition to the aforementioned input profile. In this embodiment, the parameter receiving unit 31 receives all of these as the evaluation parameter.

An SOC indicates a state of charge (the State of Charge) of the actual battery. An initial SOC is the SOC in the initial state before supplying the power to that actual battery. An SOH indicates capacity degradation of the actual battery (the State of Health). These evaluation parameters are set in advance by the user and input into the control device 30.

Furthermore, the parameter receiving unit 31 receives battery capacity of the actual battery as a system parameter, apart from the evaluation parameter.

The parameter receiving unit 31 may also receive, as the system parameter, a DCR (dynamic contact resistance) profile obtained in advance based on the aforementioned input profile, or the resistance value of the heater as the aforementioned heat generating element 12.

Some or all of the evaluation parameters received by the parameter receiving unit 31 are output to and stored in a calculation data storage unit 35.

Next, the SOC calculation unit 32 calculates the SOC of the actual battery, which changes over time based on the aforementioned input profile (S2). Prior to this SOC calculation, the simulation start time, i.e., the simulation time, is initialized.

In this embodiment, the SOC of the actual battery changes moment by moment as the current is supplied to the actual battery. The SOC at each moment can be calculated by dividing a cumulative value of the supplied current and the time by the battery capacity of the actual battery.

Therefore, the SOC calculation unit 32 is configured to calculate the SOC that changes over time using the input profile received by the parameter receiving unit 31 and the battery capacity of the actual battery.

Specifically, the SOC calculation unit 32 calculates the cumulative value of the supplied current to the actual battery and the time based on the input profile. The SOC calculation unit 32 then divides this cumulative value by the capacity of the actual battery to calculate the rate of change of the SOC over time. Using this rate of change and the initial SOC received by the parameter receiving unit 31, the time-dependent change of the SOC is calculated.

The SOC calculation unit 32 obtains calculation formulas and coefficients required for calculating the SOC that changes over time from the calculation data storage unit 35.

Next, the resistance value calculation unit 33 calculates the resistance value of the actual battery that changes over time when the current, the voltage, or the power based on the input profile is applied to the actual battery (S3).

The resistance value calculation unit 33 calculates the resistance value using at least the evaluation parameters received by the parameter receiving unit 31. Specifically, the resistance value calculation unit 33 calculates the resistance value using the profile of the current supplied to the actual battery, the SOC that changes over time calculated by the SOC calculation unit 32, the SOH of the actual battery, and the simulated battery temperature detected by the first temperature detection device T1.

The control device 30 of this embodiment further includes the calculation data storage unit 35, as shown in Fig. 3, which stores the calculation data for calculating the SOC, the resistance value, and/or the supply power.

Specifically, this calculation data storage unit 35 stores, as calculation data, a conversion table for converting the aforementioned evaluation parameters into the resistance values.

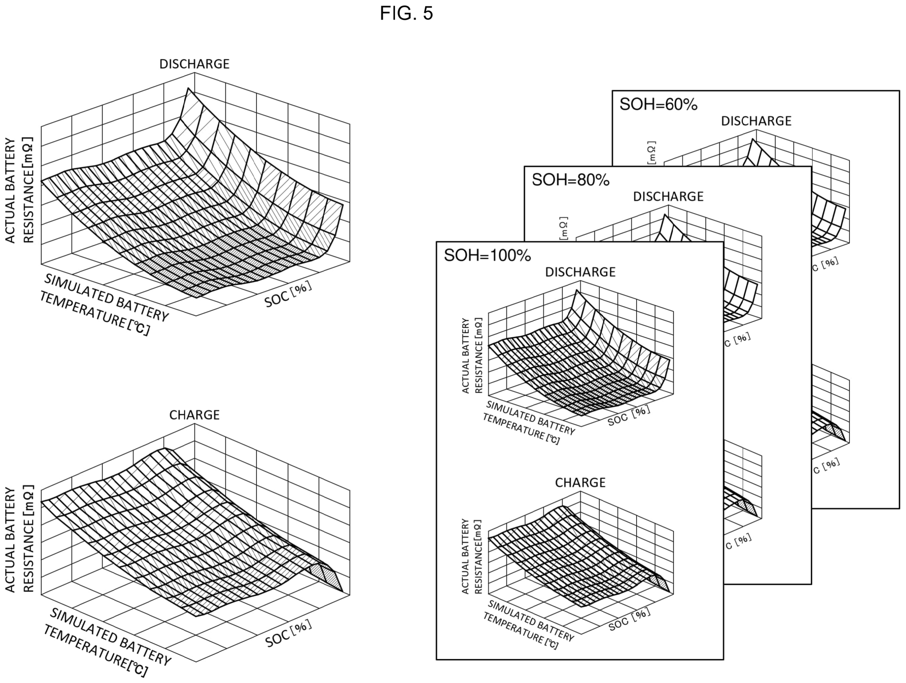

This conversion table is a three-dimensional map, as shown in Fig. 5, with the X-axis, Y-axis, and Z-axis set to the simulated battery temperature, the actual battery resistance value, and the actual battery SOC, respectively. This conversion table, being the three-dimensional map, is created in advance for various SOHs. For example, the three-dimensional map for the actual battery is first created using the actual battery. Specifically, by preparing the actual batteries corresponding to multiple SOHs, changing the temperature of the actual battery, and acquiring the resistance value of the actual battery and the SOC of the actual battery when discharging under a specified condition, the three-dimensional map for the actual battery corresponding to multiple SOHs can be pre-created. The three-dimensional map shown in Fig. 5 is created as the three-dimensional map for the simulated battery using the pre-created three-dimensional map for the actual battery. Therefore, in the three-dimensional map shown in Fig. 5, the temperature of the actual battery is replaced with the temperature of the simulated battery.

The resistance value calculation unit 33 then calculates the resistance value of the actual battery corresponding to the temperature of the simulated battery detected by the first temperature detection unit T1 and the SOC of the actual battery at that time calculated by the SOC calculation unit 32, while referring to the three-dimensional map corresponding to the SOH received by the parameter receiving unit 31.

The actual battery resistance value calculated by the resistance value calculation unit 33 is output to the power supply control unit 34.

The power supply control unit 34 then controls the power supply device 20 using the actual battery resistance value, which changes over time, calculated by the resistance value calculation unit 33.

Specifically, this power supply control unit 34 calculates the supply current to be supplied to the simulated battery 10 based on a ratio of the resistance value of the actual battery to the resistance value of the simulated battery 10 and the supply current (i.e., the supply current indicated by the input profile) to be supplied to the actual battery.

The resistance value of the simulated battery 10 is the resistance value of the heat generating element 12 to which the current is supplied. When attempting to accurately simulate the total heat generation or the surface temperature distribution, the dependence of this resistance value on the temperature of the heat generating element 12 cannot be ignored. Therefore, the power supply control unit 34 acquires the heat generating element temperature detected by the first temperature detection device T1 and sequentially calculates the resistance value of the simulated battery based on this heat generating element temperature.

Then, the power supply control unit 34 calculates the supplied power supplied to the simulated battery 10 using the supplied current supplied to the simulated battery 10 and the resistance value of the simulated battery 10, and outputs a power indication representing a magnitude of this supplied power to the power supply device 20 (S5). Note that the supplied power can be calculated by multiplying the square of the supplied current by the resistance value.

The supplied power calculated by the supply power control unit 34 is output to and stored in the calculation data storage unit 35.

As shown in Fig. 4, the control device 30 of this embodiment, after outputting the power indication to the power supply device 20, refers to a forced shutdown flag to determine whether to interrupt an operation of the system (S6). If forced shutdown is not performed, it then refers to a sequence statement indicating sequence progress to determine whether a preset sequence has ended (S7). If the sequence has ended, the operation of the system terminates. If the sequence has not ended, the process returns to S2 and repeats the operations from S2 to S7, utilizing various data stored in the calculation data storage unit 35 at this point.

According to the battery case evaluation system 100 configured in this manner, the resistance value of the actual battery, which changes over time, is calculated based on the simulated battery temperature and the input profile. The power supply device 20 is then controlled using this calculated resistance value. This allows the thermal behavior of the actual battery to be accurately simulated while considering the constantly fluctuating resistance value of the actual battery, enabling efficient evaluation of the battery case (BC).

Furthermore, using the simulated battery 10 avoids the risk (e.g., ignition due to electrode damage from impact during handling of the actual battery, or ignition that could occur if the actual battery is mistakenly overcharged) of ignition that could occur when using the actual battery.

Moreover, by setting the resistance of the simulated battery 10 higher than that of the actual battery, it becomes possible to simulate the thermal behavior of the actual battery under high current conditions by applying a low current to the simulated battery 10, thereby eliminating the need for large equipment power supplies.

Furthermore, since the SOC calculation unit 32 calculates the SOC of the actual battery, which changes over time, based on the input profile, and the resistance value calculation unit calculates the resistance value of the actual battery while considering not only the simulated battery temperature and input profile but also the SOC of the actual battery, which fluctuates moment by moment, the thermal behavior of the actual battery can be simulated with greater accuracy.

Furthermore, since the SOC is calculated based on the input profile, it eliminates the need for a process that repeatedly charges and discharges the actual battery to generate the SOC under various conditions.

Furthermore, since the parameter receiving unit 31 receives the battery capacity of the actual battery, and this battery capacity is used for calculating the SOC by the SOC calculation unit 32, thermal behavior can be simulated for the actual batteries with various battery capacities.

Moreover, since the parameter receiving unit 31 receives the initial SOC of the actual battery and the SOH of the actual battery as evaluation parameters, it is possible to simulate the thermal behavior of the actual battery under various operating conditions.

Furthermore, since at least one of the heat generating element 12 or the heat diffusing element 13 constituting the simulated battery 10 is formed with a predetermined pattern capable of reproducing the surface temperature distribution of the actual battery, it becomes possible to reproduce various surface temperature distributions of the actual batteries. This contributes to simulating the thermal behavior, such as heat conduction between the simulated battery and the surrounding components.

Furthermore, since the heat generating element 12 is formed with the predetermined dense and sparse pattern, the thermal behavior of the simulated battery 10 can be made closer to that of the actual battery.

The present invention is not limited to the above-described embodiments.

For example, in the above embodiment, the resistance value calculation unit 33 obtains the resistance value of the simulated battery 10 using the conversion table. However, the resistance value may also be obtained using a pre-created simulation model. Specifically, the evaluation parameter received by the parameter receiving unit 31 may be input and a simulation model may be created beforehand that outputs the resistance value of the simulated battery 10 corresponding to the input evaluation parameter. This simulation model may then be stored in the calculation data storage unit 35 as the calculation data.

Furthermore, while the input profile received by the parameter receiving unit 31 as one of the evaluation parameters in the above embodiment indicates the time-dependent change in the current applied to the simulated battery 10, it may also indicate the time-dependent change in the voltage applied to the simulated battery 10, or the time-dependent change in the power applied to the simulated battery 10.

Furthermore, while the above-described embodiment uses both the initial SOC and all of the SOH values as the evaluation parameters, it is not necessary to use all of them. They may be appropriately selected or omitted based on the evaluation purpose and other considerations.

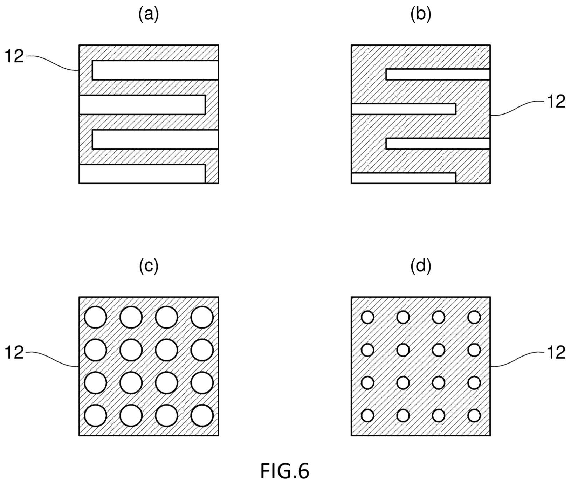

Additionally, the pattern of the heat generating element 12 is not limited to the serpentine pattern described in the above-mentioned embodiment. The heat generating element 12 may be arranged around multiple regions forming rectangular or circular shapes, as exemplified in Fig. 6(a) to Fig. 6(d), or around multiple regions forming elliptical, triangular, or polygonal shapes, although not shown. Specifically, the multiple regions enclosed by this heat generating element 12 may all be of the same type or may include mixed shapes. They may all be the same size or may include mixed sizes. Furthermore, the heat generating element may have a predetermined protrusion and recess pattern formed on it.

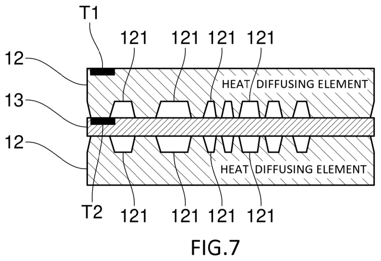

Furthermore, while the heat generating element 12 is formed with a predetermined dense and sparse pattern in the above embodiment, as shown in Fig. 7, the heat diffusing element 13 may also be formed with a predetermined protrusion and or recess pattern. More specifically, the predetermined protrusion and or recess pattern may be formed by providing recesses 121 in a portion of either the surface of the heat diffusing element 13 that holds the heat generating element 12, or the opposite surface, or both surfaces. Alternatively, the heat diffusing element 13 may be formed with the predetermined dense and sparce pattern.

This arrangement creates a space within the recesses 121. Compared to a situation where the heat generating element 12 and the heat diffusing element 13 are in a directly attached state, this space makes it more difficult for the temperature to transfer. As a result, areas where the surface temperature of the actual battery locally appears lower can also be represented on the simulated battery. Consequently, the simulated battery 10 can accurately simulate the heat diffusion behavior of the actual battery.

The predetermined pattern of either or both the heat generating element 12 and the heat diffusing element 13 may be obtained through machine learning. More specifically, an embodiment may employ a learning model that is machine learned using the surface temperature distribution of the actual battery as an explanatory variable and a predetermined pattern such as the shape or the density of either or both the heat generating element 12 and the heat diffusing element 13 as the target variable. In this case, the training data used for machine learning may include, for example, a dataset linking the surface temperature distribution of the actual battery with predetermined patterns such as the shape and/or density of either or both the heat generating element 12 and the heat diffusing element 13.

By inputting the pre-obtained surface temperature distribution data of the actual battery into the learning model, it is possible to output the predetermined patterns, such as the shape and/or density, of either or both of the heat generating element 12 or the heat diffusing element 13. This enables more accurate simulation of the surface temperature distribution.

In addition, it is also possible to use the learning model that is machine learned by adding the time-dependent change in the surface temperature distribution of the actual battery to the dataset that is used as the training data. This also enables the input of the time-dependent change data of the surface temperature distribution to derive the patterns capable of simulating the surface temperature distribution.

Furthermore, when employing the predetermined patterns for either or both of the heat generating element 12 or heat diffusing element 13 as described above, the battery case evaluation system of the present invention need not necessarily include a resistance value calculation unit that calculates the resistance value of the actual battery, which changes over time, based on the simulated battery temperature and the input profile.

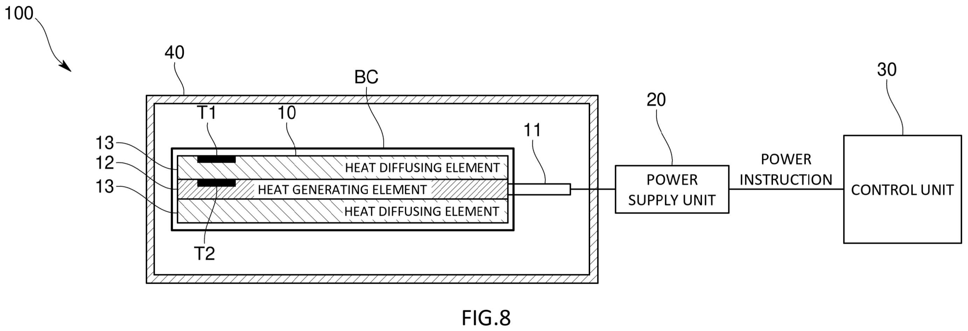

Furthermore, the battery case evaluation system 100 may also include a constant-temperature chamber 40, as shown in Fig. 8, which houses the simulated battery 10 and maintains it at a predetermined temperature.

Moreover, the evaluation target of the battery case evaluation system 100, in other words, the destination for power supply from the power supply device 20, may be not only the simulated battery 10, but also a battery case comprising at least some of the following: reinforcing members such as frames, cooling plates, water cooling pipes, cooling components such as cooling fins, or electronic devices such as junction boxes.

Furthermore, the power supply control unit 34 may perform feedback control of the power supplied to the simulated battery 10 so that the total heat generation of the simulated battery 10 approaches a target total heat generation (specifically, the total heat generation of the actual battery obtained beforehand).

With such a configuration, the heat buildup of the actual battery can be simulated using the simulated battery 10.

The battery case evaluation system 100 according to the present invention can also be used in cases where the SOC changes over time are not required, such as when evaluation is desired at a specific SOC value (e.g., 100%) of the actual battery being simulated. In such cases, the control device need not include the functionality of the SOC calculation unit 32.

Furthermore, while the aforementioned embodiment describes the control device's operation as a sequence format, it may also be a manual operation format where various conditions are entered manually each time without setting a sequence.

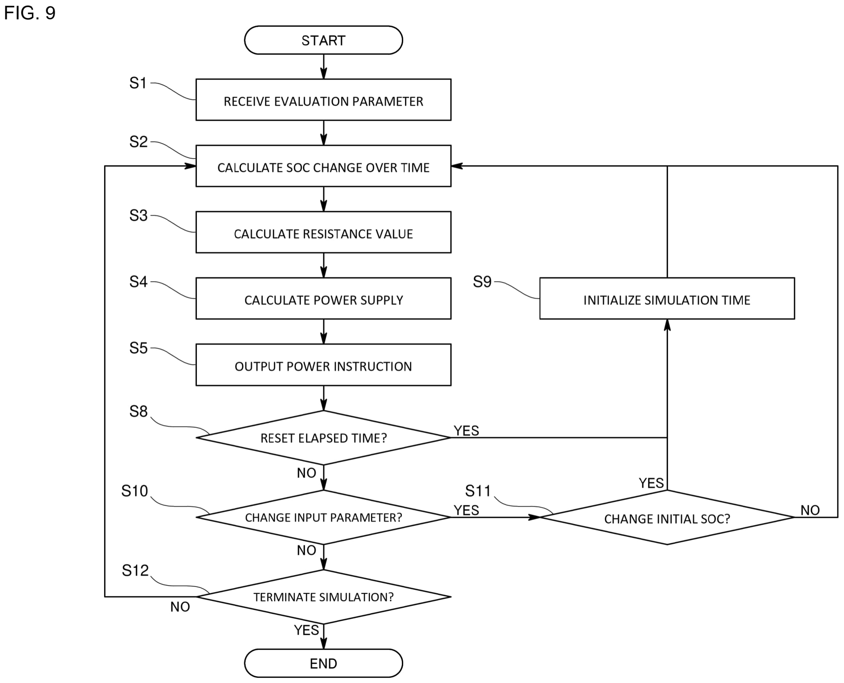

In this case, as shown in Fig. 9, after the power instruction to the power supply device 20 is output, the control device 30 checks a reset flag to determine whether to reset the elapsed time (S8). If the elapsed time is reset, the simulated time is initialized (S9), and the process returns to S2. If the elapsed time is not reset, the control device 30 then checks a parameter update flag to determine whether to change the input parameter (S10).

If the input parameter is changed in S10, the control device 30 then checks an initial SOC update flag to determine whether to change the initial SOC (S11). If the initial SOC is changed, it proceeds to S9, initializes the simulated time, and then returns to S2. If the initial SOC is not changed, it returns to S2 without initializing the simulated time.

On the other hand, if the input parameter is not changed in S10, the system then checks a termination flag to determine whether to terminate the simulation (S12). If the simulation is not terminated, the system returns to S2.

Furthermore, the battery case evaluation system 100 of the above embodiment is configured to calculate the resistance value of the actual battery that changes over time and to simulate the thermal behavior of the actual battery using only this calculated resistance value, but it is not limited to this. In other embodiments, the battery case evaluation system 100 may be configured to calculate an entropy change occurring during the charging and discharging of the actual battery, in addition to the resistance value of the actual battery that changes over time, and to further use this calculated entropy change to simulate the thermal behavior of the actual battery.

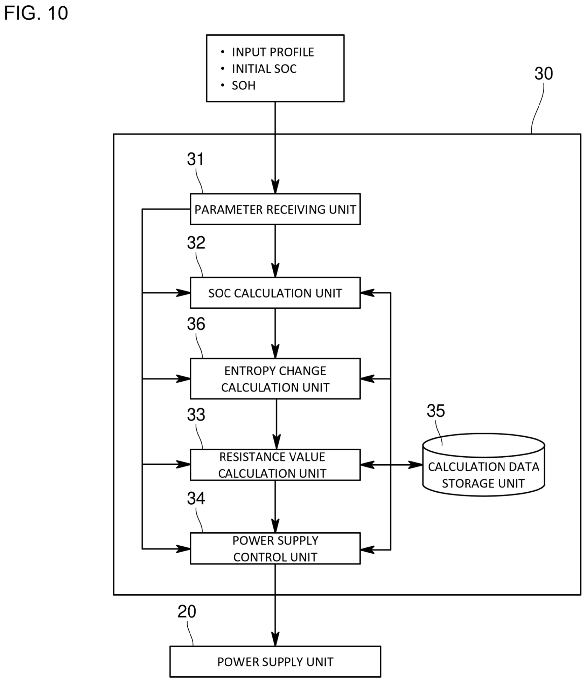

Specifically, in another embodiment, as shown in Fig. 10, the control device 30 may further function as an entropy change calculation unit 36. This entropy change calculation unit 36 calculates the entropy change using the SOC that changes over time, as calculated by the SOC calculation unit 32. The entropy change of the actual battery calculated by the entropy change calculation unit 36 arises from electrochemical reactions during the charging and discharging of the actual battery and changes over time. In this embodiment, the calculation data storage unit 35 stores conversion table data and/or calculation formula data for converting the SOC calculated by the SOC calculation unit 32 into the entropy change, as entropy change calculation data. The conversion table indicated by the entropy change calculation data shows, for example, the relationship between the SOC (%) and the entropy change ΔS (J/mol·K) corresponding to the SOC.

In the actual battery, the behavior of the reaction heat caused by the entropy change differs between charging and discharging. Specifically, an endothermic reaction occurs during charging, while an exothermic reaction occurs during discharging. Therefore, the calculation data storage unit 35 stores both the first entropy change calculation data, which is conversion data for charging, and the second entropy change calculation data, which is conversion data for discharging, as the entropy change calculation data.

In this embodiment, the power supply control unit 34 controls the power supply device 20 using the resistance value calculated by the resistance value calculation unit 33 and the entropy change calculated by the entropy change calculation unit 36. The power supply control unit 34 calculates the supply power $P_e$ and the supply current $I_e$ to the simulated battery 10 using, for example, the following equations (1) and (2) and controls the power supply device 20 to output the calculated supply power $P_e$ and the calculated supply current $I_e$.

$$P_e = I_b^2 \times R_b + (T \cdot \Delta S / F) \times I_b \qquad (1)$$

$$I_e = [(R_b / R_n) \times I_b^2 + \{(T \cdot \Delta S) / (F \cdot R_n)\} \times I_b]^{1/2} \qquad (2)$$

Here,

$R_b$: Resistance value of the actual battery
$R_n$: Resistance value of the simulated battery
$I_b$: Supply current to the actual battery
T: Temperature of the actual battery (temperature of the simulated battery)
ΔS: Entropy change
F: Faraday constant

In actual batteries, both the Joule heating due to the internal resistance and the reaction heat (exothermic and endothermic) caused by the entropy change during charging and discharging occur. Depending on the charging and discharging conditions, the endothermic reaction heat can sometimes exceed the Joule heating, resulting in overall endothermic behavior. Therefore, the battery case evaluation system 100 of other embodiment may include a cooling mechanism to cool the simulated battery 10. Examples of the cooling mechanisms include, but are not limited to, the Peltier elements, cooling fans, and cooling water circulation devices. With such a configuration, the heat generating element 12 and the cooling mechanism can simulate not only the battery's exothermic behavior but also its endothermic behavior during the simulated operation.

Furthermore, in other embodiments, the battery case evaluation system 100 may, when not equipped with a cooling mechanism and thus unable to simulate the actual battery's endothermic behavior, output information during the simulated operation such as the fact that the thermal behavior of the simulated battery deviates from the thermal behavior of the actual battery, or the degree of such deviation to a display or similar device.

Alternatively, in another embodiment, the battery case evaluation system 100 may, when it lacks a cooling mechanism and cannot simulate the actual battery's endothermic behavior, take into account the endothermic amount during the actual battery's endothermic behavior when simulating the exothermic behavior during simulated operation. For example, by limiting the heat supplied to the simulated battery during the simulation of its exothermic behavior, the total heat generated by the simulated battery 10 throughout the simulation may be set to account for both the exothermic behaviors and the endothermic behaviors of the actual battery.

In another embodiment of the battery case evaluation system 100, the simulated battery 10 may be configured to reproduce not only the surface temperature distribution of the actual battery but also the time-dependent change in the actual battery's surface temperature.

To enable simulation of the time-dependent change in the actual battery's surface temperature, the simulated battery 10 in this embodiment has at least one of the heat generating element 12 or the heat diffusing element 13 formed with a predetermined pattern (shape and or dense and sparce pattern) capable of reproducing the time-dependent change in the actual battery's surface temperature.

Specifically, the time-dependent change in the actual battery's heat generation is calculated using the time-dependent change in the actual battery's current value, voltage value, or resistance value. Based on this calculated heat generation of the actual battery, the time-dependent change in the surface temperature of the actual battery is calculated. The heat diffusing element 12 or the heat generating element 13 is formed with the predetermined shape or dense and sparce pattern such that its surface temperature changes equivalently to the calculated time-dependent change in the surface temperature of the actual battery.

Furthermore, the battery case evaluation system 100 may convert the calculated time-dependent change in the actual battery's surface temperature into the time-dependent change in the heat generation amount within the simulated battery 10. Based on this converted time-dependent change in the heat generation, it may calculate the time-dependent change in the power supply amount to the simulated battery 10. Based on this calculated time-dependent change in the power supply amount, it may control the power supply device 20.

In another embodiment of the battery case evaluation system 100, the arrangement pattern of the heat generating elements 12 and/or the heat diffusing elements 13 may be configured to reproduce the surface temperature distribution of the actual battery. For example, the actual battery may be driven under various conditions beforehand to obtain its surface temperature distribution, and the heat generating elements 12 and/or the heat diffusing elements 13 may be arranged in a predetermined pattern capable of simulating the obtained surface temperature distribution.

In yet another embodiment of the battery case evaluation system 100, the heat generating elements 12 may be arranged densely or the heat diffusing elements 13 may be arranged sparsely (or less densely) only in areas where the actual battery's surface temperature is predicted to be high (e.g., the connection area with the tab 11 and/or its vicinity).

In another embodiment of the battery case evaluation system 100, the heat generating element 12 may be configured as a variable resistor or a switchable circuit, allowing the heat output to be adjusted by arbitrarily changing the resistance value. The control device 30 may adjust the heat output of the heat generating element 12 in response to the time-dependent changes in the surface temperature distribution calculated or obtained from actual measurements.

In another embodiment of the battery case evaluation system 100, the position of the heat generating element 12 or the heat diffusing element 13 may be configured to be changeable. The control device 30 may adjust the position of the heat generating element 12 or the heat diffusing element 13 based on the time-dependent change in the surface temperature distribution calculated or actually measured.

The disclosure of the present specification also includes battery case evaluation systems of modes A to E. The disclosure of the present specification also includes the battery case evaluation systems of modes A to E that freely combine the respective components provided in the battery case evaluation system 100 of the aforementioned embodiment.

(Mode A)

A battery case evaluation system for evaluating the thermal characteristics of a battery case constituting a battery pack or components of that battery case, comprising,

a simulated battery installed within that battery case to simulate heat generation of an actual battery which is a component of the battery pack and
a power supply device supplying power to the simulated battery, wherein
the simulated battery comprises
a heat generating element supplied with power from the power supply device, and
a heat diffusing element that holds the heat generating element and diffuses heat emitted by the heat generating element, wherein
at least one of the heat generating element or the heat diffusing element is formed in a predetermined pattern capable of reproducing a surface temperature distribution of the actual battery.

(Mode B)

A battery case evaluation system as described in Mode A, further comprising

a temperature detection device for detecting the simulated battery temperature, which is the temperature of the simulated battery and
a control device for controlling the power supply device, wherein
the control device controls the power supply device based on the temperature of the simulated battery detected by the temperature detection device and a predetermined target temperature.

(Mode C)

A battery case evaluation system as described in Mode A or B, wherein the heat generating element or the heat diffusing element is formed with a predetermined dense and sparse pattern or a predetermined uneven pattern.

In this Mode C, for example, the columnar heat generating element may be formed with a dense and sparse pattern, or the heat generating element may be formed with a predetermined uneven pattern. Similarly, the heat diffusing element may be formed with a dense and sparce pattern, and the heat generating element may be formed with a predetermined uneven pattern.

(Mode D)

A battery case evaluation system as described in any one of the modes A to C, wherein the pattern of the heat generating element or the heat diffusing element is obtained by applying a machine learning model to the surface temperature distribution of the actual battery.

(Mode E)

A battery case evaluation system as described in any one of modes A to D, wherein at least one of the heat generating element and the heat diffusing element is formed with a predetermined pattern capable of reproducing the time-dependent change in the surface temperature of the actual battery.

It goes without saying that the present invention is not limited to the above embodiments and various modifications are possible within the scope of the invention without departing from its spirit.

**Possible applications in industry**

According to the battery case evaluation system of the present invention described above, the thermal behavior of the battery can be simulated with higher accuracy than conventional methods.

**Explanation of Symbols**

|     |                                  |
|-----|----------------------------------|
| 100 | battery case evaluation system   |
| 10  | simulated battery                |
| 11  | tab                              |
| 12  | heat generating element          |
| 13  | heat diffusing element           |
| 20  | power supply device              |
| 30  | control device                   |
| 31  | parameter receiving unit         |
| 32  | SOC calculation unit             |
| 33  | resistance value calculation unit|
| 34  | power supply control unit        |
| 35  | calculation data storage unit    |

**Claims**

1. A battery case evaluation system for evaluating thermal characteristics of a battery case constituting a battery pack or a component part of the battery case, comprising,

   a simulated battery that is installed within the battery case for simulating thermal behavior of an actual battery which is a component part of the battery pack,
   a temperature detection device that detects a simulated battery temperature, which is a temperature of the simulated battery,
   a power supply device that supplys power to the simulated battery, and
   a control device that controls the power supply device, wherein
   the control device comprises
   a parameter receiving unit that receives an input profile indicating time-dependent change of a current, a voltage, or power applied to the actual battery as one of evaluation parameters,
   a resistance value calculation unit that calculates a resistance value of the actual battery, which changes over time, based on the simulated battery temperature and the input profile, and
   a power supply control unit that controls the power supply device using the resistance value calculated by the resistance value calculation unit.

2. The battery case evaluation system described in claim 1, wherein

   the control device further comprises an SOC calculation unit that calculates an SOC of the actual battery, which changes over time, based on the input profile, and

the resistance value calculation unit calculates the resistance value of the actual battery using the SOC calculated by the SOC calculation unit, in addition to the simulated battery temperature and the input profile.

3. The battery case evaluation system described in claim 2, wherein

the parameter receiving unit receives a battery capacity of the actual battery, and the SOC calculation unit calculates the SOC that changes over time using the input profile and the battery capacity.

4. The battery case evaluation system described in either one of claim 1 through claim 3, wherein the parameter receiving unit receives, in addition to the input profile, at least one of an initial SOC of the actual battery or an SOH of the actual battery as the evaluation parameter.

5. The battery case evaluation system described in either one of claim 1 through claim 4, wherein

the resistance value calculation unit has a conversion table for converting the evaluation parameter received by the parameter receiving unit into the resistance value, or a simulation model that outputs the resistance value using the evaluation parameter received by the parameter receiving unit.

6. The battery case evaluation system described in either one of claim 1 through claim 5, wherein

the control device further comprises an entropy change calculation unit that calculates an entropy change generated accompanied by charging and discharging of the actual battery, and

the power supply control unit controls the power supply device using the resistance value calculated by the resistance value calculation unit and the entropy change calculated by the entropy change calculation unit.

7. The battery case evaluation system described in claim 6 citing claim 2 or claim 3, wherein

the entropy change calculation unit calculates the entropy change using table data or calculation formula data for converting the SOC calculated by the SOC calculation unit into the entropy change occurring in the actual battery.

8. The battery case evaluation system described in either one of claim 1 through claim 7, wherein

the simulated battery comprises

a heat generating element to which power is supplied from the power supply device, and

a heat diffusing element that holds the heat generating element and that diffuses heat emitted by the heat generating element, and

at least one of the heat generating element or the heat diffusing element is formed with a predetermined pattern that is capable of reproducing surface temperature distribution of the actual battery.

9. The battery case evaluation system described in claim 8, wherein

the simulated battery has a cooling mechanism for cooling itself.

10. The battery case evaluation system described in claim 8 or claim 9, wherein

the heat generating element or the heat diffusing element is formed with a predetermined dense and sparce pattern or a predetermined uneven pattern.

11. The battery case evaluation system described in either one of claim 8 through claim 10, wherein

the pattern of the heat generating element or the heat diffusing element is obtained by applying a machine learning model to the surface temperature distribution of the actual battery.

12. The battery case evaluation system described in either one of claim 8 through claim 11, wherein

at least one of the heat generating element or the heat diffusing element is formed with the predetermined pattern capable of reproducing the time-dependent change in the surface temperature of the actual battery.

13. A battery case evaluation program for evaluating thermal characteristics of a battery case constituting a battery pack or a component part of the battery case, comprising a simulated battery that is installed in the battery case for simulating thermal behavior of an actual battery which is a component part of the battery pack, a temperature detection device that detects a simulated battery temperature, which is the temperature of the simulated battery, a power supply device that supplies power to the simulated battery, and a control device that controls the power supply device, and

making the control device produce functions
as a parameter receiving unit that receives an input profile indicating the time-dependent change in a current, a voltage, or power supplied to the actual battery as one of the evaluation parameters,
a resistance value calculation unit that calculates a resistance value of the actual battery, which changes over time, based on the simulated battery temperature and the input profile, and
a power supply control unit that controls the power supply device using the resistance value calculated by the resistance value calculation unit.

14. A battery case evaluation method for evaluating thermal characteristics of a battery case constituting a battery pack or a component of the battery case, and that is used together with a battery case evaluation system comprising a simulated battery that is installed in the battery case for simulating thermal behavior of an actual battery which is a component part of the battery pack, a temperature detection device that detects a simulated battery temperature, which is a temperature of the simulated battery, a power supply device that supplies power to the simulated battery, and a control device that controls the power supply device, wherein comprising

a step of causing the control device to receive an input profile indicating time-dependent change of a current, a voltage, or power supplied to the actual battery as one of evaluation parameters,
a step of causing the control device to calculate a resistance value of the actual battery, which changes over time, based on the simulated battery temperature and the input profile, and
a step of causing the control device to control the power supply device using the calculated resistance value.

FIG.1

FIG.2

FIG.3

FIG. 4

START

S1 — RECEIVE EVALUATION PARAMETER

S2 — CALCULATE SOC CHANGING OVER TIME

S3 — CALCULATE RESISTANCE VALUE

S4 — CALCULATE POWER SUPPLY

S5 — OUTPUT POWER INSTRUCTION

S6 — FORCED SHUTDOWN

NO

S7 — SEQUENCE END?

NO

END

EP 4 737 919 A1

FIG. 5

SOH=60%

DISCHARGE

SOH=80%

DISCHARGE

SOH=100%

DISCHARGE

ACTUAL BATTERY RESISTANCE[mΩ]

SIMULATED BATTERY TEMPERATURE [℃]

SOC [%]

CHARGE

ACTUAL BATTERY RESISTANCE[mΩ]

SIMULATED BATTERY TEMPERATURE [℃]

SOC [%]

DISCHARGE

ACTUAL BATTERY RESISTANCE[mΩ]

SIMULATED BATTERY TEMPERATURE[℃]

SOC[%]

CHARGE

ACTUAL BATTERY RESISTANCE[mΩ]

SIMULATED BATTERY TEMPERATURE[℃]

SOC[%]

FIG.6

EP 4 737 919 A1

T1

12

13

12

121 121 121 121

HEAT DIFFUSING ELEMENT

HEAT DIFFUSING ELEMENT

T2 121 121 121 121

FIG.7

FIG.8

EP 4 737 919 A1

FIG. 9

FIG. 10

- INPUT PROFILE
- INITIAL SOC
- SOH

30

31 PARAMETER RECEIVING UNIT

32 SOC CALCULATION UNIT

36 ENTROPY CHANGE CALCULATION UNIT

33 RESISTANCE VALUE CALCULATION UNIT

35 CALCULATION DATA STORAGE UNIT

34 POWER SUPPLY CONTROL UNIT

20 POWER SUPPLY UNIT

EP 4 737 919 A1

**EP 4 737 919 A1**

## INTERNATIONAL SEARCH REPORT

| International application No. |
|---|
| **PCT/JP2024/023511** |

### A. CLASSIFICATION OF SUBJECT MATTER

*G01R 31/367*(2019.01)i; *G01N 25/18*(2006.01)i; *G01R 31/382*(2019.01)i; *G01R 31/385*(2019.01)i; *G01R 31/389*(2019.01)i; *G01R 31/392*(2019.01)i; *H01M 10/48*(2006.01)i

FI: G01R31/367; G01N25/18 J; H01M10/48 301; H01M10/48 P; G01R31/382; G01R31/385; G01R31/392; G01R31/389

According to International Patent Classification (IPC) or to both national classification and IPC

### B. FIELDS SEARCHED

Minimum documentation searched (classification system followed by classification symbols)

G01R31/36; G01N25/18; H01M10/48; G01R31/00; H01M10/60; H02J7/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | CN 115545335 A (CAMEL GROUP WUHAN OPTICS VALLEY R&D CENTER CO., LTD.) 30 December 2022 (2022-12-30) entire text, all drawings | 1-14 |
| A | JP 2020-54214 A (SEKISUI CHEMICAL CO., LTD.) 02 April 2020 (2020-04-02) entire text, all drawings | 1-14 |
| A | JP 2018-147680 A (SUMITOMO ELECTRIC INDUSTRIES, LTD.) 20 September 2018 (2018-09-20) entire text, all drawings | 1-14 |
| A | JP 2022-41144 A (GS YUASA INTERNATIONAL LTD.) 11 March 2022 (2022-03-11) entire text, all drawings | 1-14 |
| A | US 2018/0031641 A1 (JOHNSON CONTROLS TECHNOLOGY CO.) 01 February 2018 (2018-02-01) entire text, all drawings | 1-14 |

☐ Further documents are listed in the continuation of Box C.  ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **23 July 2024** | **06 August 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

25

| INTERNATIONAL SEARCH REPORT Information on patent family members | | International application No. PCT/JP2024/023511 |
|---|---|---|

| Patent document cited in search report | Publication date (day/month/year) | Patent family member(s) | Publication date (day/month/year) |
|---|---|---|---|
| CN 115545335 A | 30 December 2022 | (Family: none) | |
| JP 2020-54214 A | 02 April 2020 | (Family: none) | |
| JP 2018-147680 A | 20 September 2018 | (Family: none) | |
| JP 2022-41144 A | 11 March 2022 | (Family: none) | |
| US 2018/0031641 A1 | 01 February 2018 | WO 2018/022134 A1 entire text, all drawings CA 3032428 A1 | |

Form PCT/ISA/210 (patent family annex) (July 2022)

**EP 4 737 919 A1**

**Patent documents cited in the description**

- JP 2022151635 A